# EUROPÄISCHE PATENTSCHRIFT

(11) **EP 2 356 892 B1**
(45) Veröffentlichungstag und Bekanntmachung des Hinweises auf die Patenterteilung: **25.03.2015**
(21) Anmeldenummer: 09768512.7
(22) Anmeldetag: 27.11.2009
(51) Int. Cl.: H05K 7/14, G06F 1/18

(54) **BEFESTIGUNGSELEMENT FÜR EINE ERWEITERUNGSKARTE SOWIE ENTSPRECHENDE ANORDNUNG EINES BEFESTIGUNGSELEMENTS MIT EINER ERWEITERUNGSKARTE IN EINEM COMPUTERSYSTEM**
FASTENING ELEMENT FOR AN EXPANSION CARD AND CORRESPONDING ARRANGEMENT OF A FASTENING ELEMENT HAVING AN EXPANSION CARD IN A COMPUTER SYSTEM
ÉLÉMENT DE FIXATION POUR UNE CARTE D'EXTENSION ET DISPOSITION EN CONSÉQUENCE D'UN ÉLÉMENT DE FIXATION MUNI D'UNE CARTE D'EXTENSION DANS UN SYSTÈME INFORMATIQUE

(30) Priorität: 08.12.2008 DE 102008061031
(43) Veröffentlichungstag der Anmeldung: 17.08.2011
(73) Patentinhaber: Fujitsu Technology Solutions Intellectual Property GmbH, 80807 München (DE)
(72) Erfinder: FIETZ, Ralf-Peter, 33104 Paderborn (DE); HESSE, Ronny, 33175 Bad Lippspringe (DE)
(74) Vertreter: Epping - Hermann - Fischer
(86) Internationale Anmeldenummer: PCT/EP2009/065973
(87) Internationale Veröffentlichungsnummer: WO 2010/076102

(56) Entgegenhaltungen:
- US-A- 6 056 579
- US-A1- 2004 034 997
- US-A1- 2007 076 399

## Beschreibung

Die Erfindung betrifft ein Befestigungselement für eine Erweiterungskarte in einem Computersystem, wobei das Befestigungselement klammerförmig ausgebildet ist und wenigstens zwei Haltearme aufweist, die eine im Befestigungselement aufgenommene Erweiterungskarte zumindest teilweise umgreifen, und wobei das Befestigungselement an einem Halteelement eines Baugruppenträgers verrastbar ist.

Ferner betrifft die Erfindung eine Anordnung mit einem Befestigungselement und einer Erweiterungskarte, sowie deren Anordnung an einem Baugruppenträger eines Computersystems.

Computersysteme werden in immer flacherer Bauweise realisiert. Insbesondere in Blade-Serversystemen kommen deshalb schmale Erweiterungskarten, so genannte Riser-Karten, zum Einsatz, die eine Platz sparende Erweiterung der Serversysteme mit Tochterkarten oder so genannten Mezzanine-Karten ermöglichen. Erweiterungskarten werden meist senkrecht zu einer Hauptplatine, insbesondere einem Motherboard, im Server angeordnet, wobei die Erweiterungskarten mittels eines Steckers elektrisch mit Kontakten am Motherboard konnektiert werden können. Eine Erweiterungskarte fungiert also als Art "Winkelstück", sodass schließlich eine Tochterkarte an der Erweiterungskarte eingesteckt werden kann, wobei die Tochterkarte parallel zum Motherboard angeordnet ist.

Erweiterungskarten werden in Serversystemen oftmals vormontiert, wobei die Karten mittels Befestigungselementen, beispielsweise Bolzen und Schrauben, an einem Chassis oder Baugruppenträger fixiert werden und mit einem Motherboard über Steckkontakte elektrisch verbunden werden. Diese Lösung ist zwar einfach und preiswert, erlaubt jedoch keine werkzeuglose Montage. Außerdem können mechanische Verspannungen zwischen einer montierten Erweiterungskarte und dem Motherboard auftreten, falls die Erweiterungskarte beispielsweise aufgrund von Fertigungstoleranzen des Baugruppenträgers nicht exakt positioniert werden kann. Dies erschwert eine sichere elektrische Verbindung zwischen der Erweiterungskarte und dem Motherboard oder macht eine Verbindung unter Umständen unmöglich.

Ferner gestaltet sich ein Einbau von Erweiterungskarten oftmals mühsam, da eine Fixierung mittels der Befestigungselemente und eine elektrische Kontaktierung mit dem Motherboard in mehreren Montageschritten erfolgen müssen. Zum Herstellen der Steckverbindung zwischen der Erweiterungskarte und dem Motherboard muss zudem Druck auf die Rückseite der Erweiterungskarte aufgewendet werden, wobei die Gefahr besteht, Lötpins zu beschädigen, die auf der Rückseite der Erweiterungskarte angeordnet sind.

Aus den Druckschriften DE 298 22 914 U1, US 6,056,579 A, US 2004/0034997 A1 sowie US 2007/0076399 A1 sind jeweils Fixierbügel für einen CPU-Träger bekannt, um eine CPU-Karte in einem Sockel auf dem CPU-Träger fixieren zu können. Dabei wird die CPU-Karte senkrecht in den Sockel gesteckt und somit elektrisch kontaktiert. Anschließend erfolgt eine Fixierung der CPU-Karte, indem der Fixierbügel auf die CPU-Karte abgesenkt oder mit der CPU-Karte verbunden wird und am CPU-Träger verrastet wird. Dabei können nur CPU-Karten einer einheitlichen Baugröße eingesetzt werden. Derartige Befestigungssysteme sind für Erweiterungskarten der eingangs genannten Art wenig praktikabel.

Es ist eine Aufgabe der Erfindung, ein Befestigungselement für eine Erweiterungskarte in einem Computersystem zu beschreiben, das eine verbesserte Fixierung und Kontaktierung sowie eine einfachere Handhabung einer Erweiterungskarte bei ihrer Montage und Demontage ermöglicht.

Ferner besteht eine Aufgabe der Erfindung darin, eine entsprechende Anordnung eines Befestigungselements mit einer Erweiterungskarte sowie deren Anordnung an einem Baugruppenträger eines Computersystems zu beschreiben, die eine verbesserte Fixierung und Kontaktierung der Erweiterungskarte ermöglichen.

Die Aufgabe wird in einem ersten Aspekt durch ein Befestigungselement der eingangs genannten Art gelöst, wobei das Befestigungselement klammerförmig ausgebildet ist und wenigstens zwei Haltearme aufweist, die eine im Befestigungselement aufgenommene Erweiterungskarte zumindest teilweise umgreifen, wobei das Befestigungselement unverlierbar mit der Erweiterungskarte verbunden ist, und wobei das Befestigungselement an einem Halteelement eines Baugruppenträgers verrastbar ist. Das Befestigungselement weist erste Befestigungsmittel auf, die eingerichtet sind, eine im Befestigungselement aufgenommene Erweiterungskarte senkrecht zu den Haltearmen derart am Befestigungselement festzulegen, dass die Fläche der Erweiterungskarte senkrecht zu der Längsrichtung der Haltearme ist.

Die erfindungsgemäße Lösung hat den Vorteil, dass in einem derartigen Befestigungselement eine Erweiterungskarte verrastet werden kann, sodass eine einfach handhabbare Baugruppe entsteht. Die Erweiterungskarte wird vom Befestigungselement zumindest teilweise klammerförmig umgeben, sodass die Baugruppe von einem Benutzer mühelos gegriffen und einfach an einem Baugruppenträger eingerastet werden kann.

Bevorzugt sind die ersten Befestigungsmittel als Nuten ausgebildet, in denen die Erweiterungskarte fixiert werden kann. Eine Erweiterungskarte kann dabei von vorne oder von oben in das Befestigungselement eingesetzt werden. Dabei ist denkbar, einen Schutz gegen Durchrutschen der Erweiterungskarte vorzusehen, wobei Geometrieelemente des Steckers - zum Beispiel Zentrierpins bzw. Boardlocks oder Lötpins, zwischen die man Rippen tauchen lassen kann - ausgenützt werden.

Ferner wird die Aufgabe in einem zweiten Aspekt durch eine Anordnung gelöst, umfassend ein entsprechendes Befestigungselement und eine Erweiterungskarte, wobei die Erweiterungskarte einen Stecker zum Zusammenwirken mit Kontakten auf einer Platine aufweist, wobei der Stecker senkrecht zu einer Leiterplatte der Erweiterungskarte angeordnet ist und wobei die Erweiterungskarte an der dem Stecker abgewandten Seite vom Befestigungselement klammerförmig umgriffen wird und am Befestigungselement festgelegt ist. Dabei bildet die Rückseite des Befestigungselements eine Art Schutzkappe, sodass die Lötpins, welche auf der den elektrischen Steckerkontakten der Erweiterungskarte abgewandten Seite angebracht sind, sicher vor Beschädigungen geschützt sind.

Somit kann die Erweiterungskarte über das erfindungsgemäße Befestigungselement ohne Zusatzwerkzeug in einem Montageschritt an einem Baugruppenträger fixiert und elektrisch kontaktiert werden, wobei eine stabile Montage gewährleistet ist. Die Erweiterungskarte wird dabei ständig vom Befestigungselement gehalten, wobei das Befestigungselement selbst am Baugruppenträger verrastbar ist.

In einem dritten Aspekt wird die Aufgabe durch eine Anordnung gelöst, umfassend eine Baugruppe mit einem Befestigungselement und einer Erweiterungskarte der genannten Art sowie einen Baugruppenträger, wobei das Befestigungselement derart an einem Halteelement des Baugruppenträgers verrastet ist, dass der Stecker der im Befestigungselement aufgenommenen Erweiterungskarte und Kontakte einer auf dem Baugruppenträger festgelegten Platine relativ zueinander fixiert sind, wobei das Halteelement die Kontakte der Platine rahmenförmig umgibt.

Durch die rahmenförmige Anordnung des Halteelements des Baugruppenträgers um die Steckkontakte der Platine ist gewährleistet, dass Steckverbindungen zwischen der Erweiterungskarte und der Platine stabil fixiert werden, falls die Erweiterungskarte über das Befestigungselement am Baugruppenträger festgelegt wird. Sowohl die Fixierung am Baugruppenträger als auch die Kontaktierung der Erweiterungskarte an der Platine können in einem Montageschritt der Erweiterungskarte mittels des Befestigungselements ausgeführt werden, wobei die Steckerkontakte der Erweiterungskarte bei Einrasten des Befestigungselements am Baugruppenträger mit den Kontakten der Platine automatisch verbunden und fixiert werden.

Weitere Ausgestaltungen der Erfindung sind in den Unteransprüchen sowie in der Figurenbeschreibung offenbart.

Die Erfindung wird anhand mehrerer Zeichnungen näher erläutert.

Es zeigen:
- Figur 1: eine Ausführungsform eines Befestigungselements,
- Figur 2: das Befestigungselement gemäß Figur 1 mit einer darin verrasteten Erweiterungskarte,
- Figur 3: eine perspektivische Darstellung eines Teils eines Baugruppenträgers,
- Figur 4: eine perspektivische Darstellung eines Teils eines Baugruppenträgers mit einer eingehängten Platine und
- Figur 5: eine perspektivische Darstellung einer Anordnung, umfassend eine Erweiterungskarte, ein Befestigungselement, einen Teil eines Baugruppenträgers und einen Teil eines Motherboards.

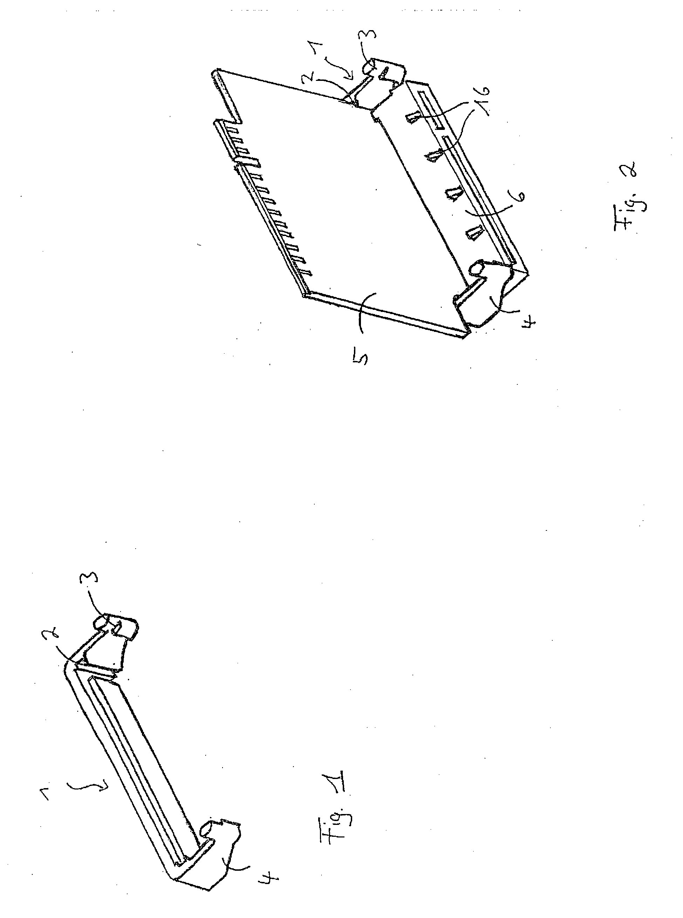

Figur 1 zeigt ein Befestigungselement 1 mit zwei Haltearmen 4, welche derart am Befestigungselement 1 angeordnet sind, dass das Befestigungselement 1 als U-förmige Halteklammer ausgebildet ist. Weiterhin sind am Befestigungselement 1 erste Befestigungsmittel 2 ausgebildet, sodass eine Erweiterungskarte im Befestigungselement 1 aufgenommen und an den ersten Befestigungsmitteln 2 fixiert werden kann. Die ersten Befestigungsmittel 2 sind hier als Nuten ausgeführt, sodass eine Erweiterungskarte entweder von oben in die Nuten eingeschoben oder von vorne in die Nuten eingeklickt werden kann. Vorzugsweise verjüngen sich die Haltearme 4 an ihren Innenseiten, sodass ein einfaches Einklicken einer Erweiterungskarte von vorne gewährleistet ist. Ferner münden die Haltearme 4 in zweite Befestigungsmittel 3, welche hier als Rasthaken ausgeführt sind, die an einem Halteelement eines Baugruppenträgers verrastbar sind. Mittels der zweiten Befestigungsmittel 3 ist das Befestigungselement 1 daher an einem Baugruppenträger festlegbar.

Figur 2 zeigt ein Befestigungselement 1 gemäß Figur 1, in dem eine Erweiterungskarte 5 aufgenommen und an den ersten Befestigungsmitteln 2 fixiert ist. Das Befestigungselement 1 umgreift dabei mit den Haltearmen 4 klammerförmig die Erweiterungskarte 5. Somit bilden die Erweiterungskarte 5 und das Befestigungselement 1 eine stabile Baugruppe, die an den Haltearmen 4 von einem Benutzer gefasst und in ein Computersystem eingesetzt werden kann. Die Erweiterungskarte 5 weist einen Stecker 6 auf, welcher senkrecht zur Leiterplatte der Erweiterungskarte 5 angeordnet ist, sodass die Leiterplatte mit dem Stecker 6 eine Art "Winkelstück" zur Erweiterung einer Platine, insbesondere eines Motherboards eines Computersystems, bildet. Weiterhin sind am Stecker 6 Führungsnasen 16 angeordnet, die den Stecker 6 bei Verrasten der Baugruppe an einem Baugruppenträger zur Kontaktierung mit Kontakten auf einer Platine auf dem Baugruppenträger führen und den Stecker zusätzlich am Baugruppenträger fixieren.

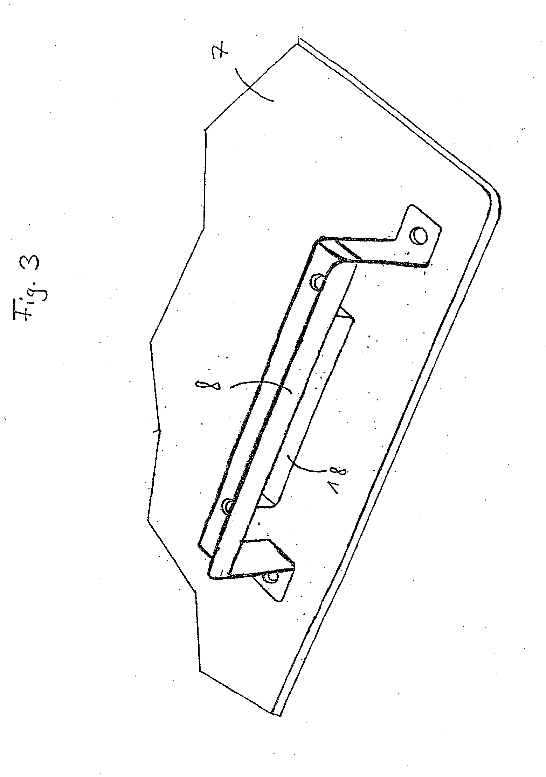

Figur 3 zeigt eine perspektivische Darstellung eines Teils eines Baugruppenträgers 7, auf dessen Oberseite ein rahmenförmiges Halteelement 8 angeordnet ist. Das Halteelement 8 kann beispielsweise aus Blech geformt und über Ösen in den Baugruppenträger 7 eingepresst sein. Das Halteelement 8 dient zur Einrahmung von Kontakten einer Platine (nicht dargestellt), welche auf der Oberseite des Baugruppenträgers 7 angeordnet werden kann. Das Halteelement 8 dient ferner einer Verrastung einer Baugruppe (nicht dargestellt), bestehend aus einem Befestigungselement 1 und einer Erweiterungskarte 5 gemäß Figur 2, wobei die Führungsnasen 16 am Stecker 6 der Erweiterungskarte 5 mittels eines bügelförmigen Führungselements 18 am Halteelement 8 geführt werden können, sodass der Stecker 6 der eingesetzten Baugruppe formschlüssig und exakt im rahmenförmigen Halteelement 8 positioniert werden kann.

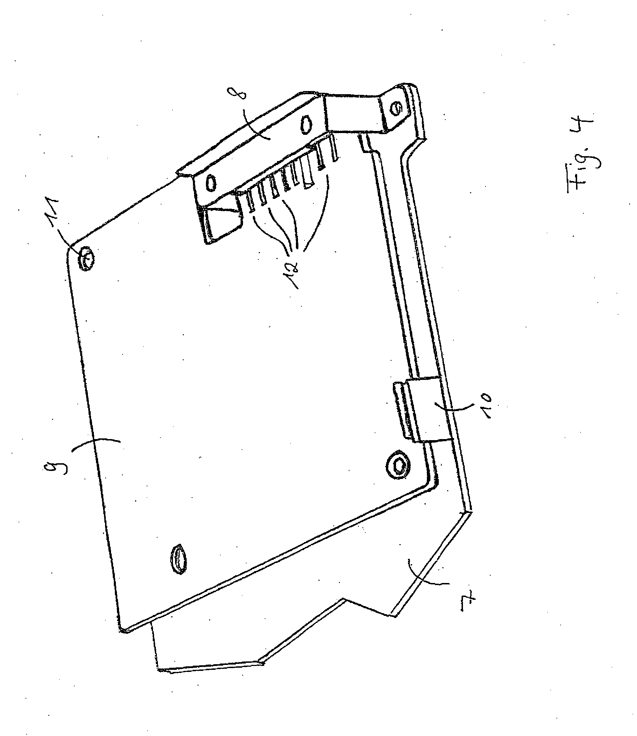

Figur 4 zeigt eine perspektivische Darstellung eines Teils eines Baugruppenträgers 7, auf dessen Oberseite eine Platine 9 angeordnet ist. Die Platine 9 kann beispielsweise ein Motherboard oder eine IO-Schnittstellenkarte in einem Blade-Serversystem sein. Die Platine 9 ist über eine Fixierung 10 am Baugruppenträger 7 festgelegt und über Öffnungen 11 positioniert, die beispielsweise mit Bolzen (nicht dargestellt) am Baugruppenträger 7 zusammenwirken. An der Platine 9 sind ferner Kontakte 12 angeordnet, welche durch ein rahmenförmiges Halteelement 8 auf dem Baugruppenträger 7 tauchen. Am Halteelement 8 kann eine Baugruppe mit einer Erweiterungskarte 5 und einem Befestigungselement 1 gemäß Figur 2 verrastet werden, wobei gleichzeitig die Kontakte 12 der Platine 9 mit einem Stecker 6 der Erweiterungskarte 5 elektrisch kontaktiert werden.

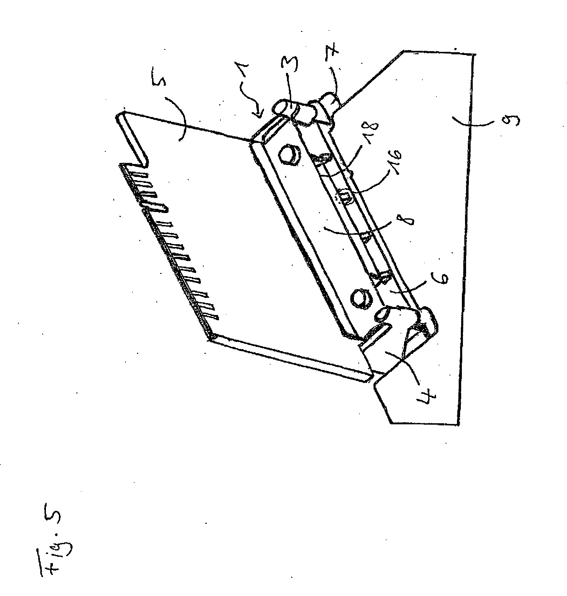

Figur 5 zeigt schließlich eine Anordnung einer Baugruppe, bestehend aus einem Befestigungselements 1 und einer Erweiterungskarte 5, mit einem Teil einer Platine 9, welche auf einem Baugruppenträger 7 gemäß Figur 4 festgelegt ist. Das Befestigungselement 1 umgreift mit seinen Haltearmen 4 klammerförmig die Erweiterungskarte 5, welche in dem Befestigungselement 1 fixiert ist. Ferner ist das Befestigungselement 1 am rahmenförmigen Halteelement 8 des Baugruppenträgers 7 mittels der zweiten Befestigungsmittel 3 verrastet. Die zweiten Befestigungsmittel 3 sind in dieser Ausführungsform als Rasthaken ausgebildet, welche am Halteelement 8 einschnappen und dieses hintergreifen, sodass die gesamte Baugruppe, bestehend aus der Erweiterungskarte 5 und dem Befestigungselement 1, am Halteelement 8 festgelegt ist. Der Stecker 6 wird über seine Führungsnasen 16 am Führungselement 18 des Halteelements 8 bei Einsetzen der Baugruppe derart geführt, dass der Stecker 6 mit Kontakten 12 der Platine 9 gemäß Figur 4 zusammenwirkt. Die Kontakte 12 werden in den Stecker 6 eingeschoben und stellen eine elektrische Verbindung zwischen der Platine 9 und der Erweiterungskarte 5 her. Mittels des Befestigungselements 1 kann eine Erweiterungskarte 5 daher in einem Montageschritt an einem Baugruppenträger 7 eines Computersystems festgelegt und gleichzeitig an ihrem Stecker 6 mit Kontakten einer Platine 9 elektrisch verbunden werden. Die Baugruppe kann dabei an den Haltearmen 4 gegriffen werden und durch Druck auf das Befestigungselement 1 mittels der zweiten Befestigungsmittel 3 am Baugruppenträger verrastet werden. Lötpins, die auf der dem Stecker 6 der Erweiterungskarte 5 abgewandten Seite angeordnet sind, werden durch das Befestigungselement 1 verdeckt, sodass keine Gefahr besteht, diese bei Montage der Erweiterungskarte 5 zu beschädigen. Zum Lösen der mechanischen und elektrischen Verbindung zwischen der Baugruppe und der Platine 9 bzw. dem Baugruppenträger 7 können die Haltearme 4 oberhalb der zweiten Befestigungsmittel 3 von einem Benutzer seitlich nach außen gedrückt werden, sodass die Rasthaken der zweiten Befestigungsmittel 3 in ihrer Hintergreifung am Haltelement 8 gelöst werden. Die Baugruppe kann dann von der Platine 9 weggedrückt und vollständig vom Baugruppenträger 7 und der Platine 9 entfernt werden. Entscheidend ist dabei, dass die Baugruppe als geschlossene Einheit verbleibt, sodass die Erweiterungskarte 5 in dem Befestigungselement 1 auch bei Lösen der Baugruppe weiterhin fixiert ist. Das Befestigungselement 1 ist also unverlierbar mit der Erweiterungskarte 5 verbunden.

In weiteren, nicht dargestellten Ausführungsformen kann ein Befestigungselement 1 beispielsweise auch zur Aufnahme von zwei oder mehreren Erweiterungskarten 5 ausgelegt sein, welche durch mehrere erste Befestigungsmittel 2 an dem Befestigungselement 1 fixiert werden können und über mehrere zweite Befestigungsmittel 3 des Befestigungselements 1 an Halteelementen 8 eines Baugruppenträgers 7 festlegbar sind. Ferner ist denkbar, in einem Befestigungselement 1 eine Erweiterungskarte 5 aufzunehmen, welche anstelle eines Steckers 6 Kontaktzungen zum Zusammenwirken mit einem Stecker auf einer Platine 9 aufweist. Dabei ist ein Befestigungselement 1 derart auszuführen, dass es eine Erweiterungskarte 5 vollständig einfasst, sodass die Erweiterungskarte 5 beispielsweise von oben auf die Platine 9 aufgesetzt werden kann, wobei die Kontaktzungen der Erweiterungskarte 5 in dem Stecker der Platine 9 einrasten und die gesamte Baugruppe an dem Baugruppenträger einrastet. Die Erweiterungskarte kann eine Riser-Karte der eingangs genannten Art, aber auch jegliche andere Erweiterungskarte für Computersysteme, wie beispielsweise eine Netzwerk- oder Graphikkarte sein. Auch die Ausführungen aller Befestigungsmittel, Rastelemente, Kontaktzungen und Stecker sowie der Halte- und Führungselemente eines Baugruppenträgers sind hier lediglich beispielhaft gewählt.

### Bezugszeichenliste

- 1: Befestigungselement
- 2: erste Befestigungsmittel
- 3: zweite Befestigungsmittel
- 4: Haltearme
- 5: Erweiterungsplatte
- 6: Stecker
- 7: Baugruppenträger
- 8: Haltelement
- 9: Platine
- 10: Fixierung
- 11: Öffnung
- 12: Kontakte
- 16: Führungsnasen
- 18: Führungselement

## Patentansprüche

1. Befestigungselement (1) für eine Erweiterungskarte (5) in einem Computersystem, wobei das Befestigungselement (1) klammerförmig ausgebildet ist und wenigstens zwei Haltearme (4) aufweist, die eine im Befestigungselement (1) aufgenommene Erweiterungskarte (5) zumindest teilweise umgreifen, wobei das Befestigungselement (1) unverlierbar mit der Erweiterungskarte (5) verbunden ist, und wobei das Befestigungselement (1) an einem Halteelement (8) eines Baugruppenträgers (7) verrastbar ist,
**dadurch gekennzeichnet, dass**
das Befestigungselement (1) erste Befestigungsmittel (2) aufweist, die eingerichtet sind, eine im Befestigungselement (1) aufgenommene Erweiterungskarte (5) senkrecht zu den Haltearmen (4) derart am Befestigungselement (1) festzulegen, dass die Fläche der Erweiterungskarte (5) senkrecht zu der Längsrichtung der Haltearme (4) ist.

2. Befestigungselement (1) nach Anspruch 1,
**dadurch gekennzeichnet, dass**
die ersten Befestigungsmittel (2) als Nuten ausgebildet sind, in denen eine Erweiterungskarte (5) fixiert werden kann.

3. Befestigungselement (1) nach Anspruch 1 oder 2,
**dadurch gekennzeichnet, dass**
an den Haltearmen (4) zweite Befestigungsmittel (3) zur Verrastung des Befestigungselements (1) an einem Halteelement (8) eines Baugruppenträgers (7) angeordnet sind.

4. Befestigungselement (1) nach Anspruch 3,
**dadurch gekennzeichnet, dass**
die zweiten Befestigungsmittel (3) als Rasthaken ausgebildet sind, die ein Halteelement (8) eines Baugruppenträgers (7) im verrasteten Zustand des Befestigungselements (1) hintergreifen.

5. Anordnung, umfassend ein Befestigungselement (1) nach einem der Ansprüche 1 bis 4 und eine Erweiterungskarte (5), wobei die Erweiterungskarte (5) einen Stecker (6) zum Zusammenwirken mit Kontakten (12) auf einer Platine (9) aufweist, wobei der Stecker (6) senkrecht zu einer Leiterplatte der Erweiterungskarte (5) angeordnet ist und wobei die Erweiterungskarte (5) an der dem Stecker (6) abgewandten Seite vom Befestigungselement (1) klammerförmig umgriffen wird und am Befestigungselement (1) festgelegt ist.

6. Anordnung nach Anspruch 5, umfassend eine Baugruppe mit einem Befestigungselement (1) und einer Erweiterungskarte (5) sowie einen Baugruppenträger (7), wobei das Befestigungselement (1) derart an einem Halteelement (8) des Baugruppenträgers (7) verrastet ist, dass der Stecker (6) der im Befestigungselement (1) aufgenommenen Erweiterungskarte (5) und Kontakte (12) einer auf dem Baugruppenträger (7) festgelegten Platine (9) relativ zueinander fixiert sind, wobei das Halteelement (8) die Kontakte (12) der Platine (9) rahmenförmig umgibt.

7. Computersystem mit einer Anordnung nach Anspruch 6, wobei das Computersystem ein Blade-Server ist.

## Claims

1. Fastening element (1) for an expansion card (5) in a computer system, wherein the fastening element (1) is in the form of a clip and has at least two holding arms (4) which at least partially engage around an expansion card (5) which is accommodated in the fastening element (1), wherein the fastening element (1) is connected to the expansion card (5) in a captive manner, and wherein the fastening element (1) can be locked to a holding element (8) of a mounting rack (7), **characterized in that** the fastening element (1) has first fastening means (2) which are designed to secure an expansion card (5), which is accommodated in the fastening element (1), to the fastening element (1) perpendicular to the holding arms (4) in such a way that the face of the expansion card (5) is perpendicular to the longitudinal direction of the holding arms (4).

2. Fastening element (1) according to Claim 1, **characterized in that** the first fastening means (2) are in the form of grooves in which an expansion card (5) can be fixed.

3. Fastening element (1) according to Claim 1 or 2, **characterized in that** second fastening means (3) for locking the fastening element (1) to a holding element (8) of a mounting rack (7) are arranged on the holding arms (4).

4. Fastening element (1) according to Claim 3, **characterized in that** the second fastening means (3) are in the form of latching hooks which engage behind a holding element (8) of a mounting rack (7) in the locked state of the fastening element (1).

5. Arrangement comprising a fastening element (1) according to one of Claims 1 to 4 and an expansion card (5), wherein the expansion card (5) has a plug (6) for interacting with contacts (12) on a printed circuit (9), wherein the plug (6) is arranged perpendicular to a printed circuit board of the expansion card (5), and wherein the fastening element (1) engages around the expansion card (5) in the manner of a clip on that side which is remote from the plug (6), and the said expansion card is secured to the fastening element (1).

6. Arrangement according to Claim 5, comprising an assembly having a fastening element (1) and an expansion card (5) and also a mounting rack (7), wherein the fastening element (1) is locked to a holding element (8) of the mounting rack (7) in such a way that the plug (6) of the expansion card (5), which is accommodated in the fastening element (1), and contacts (12) of a printed circuit (9), which is secured on the mounting rack (7), are fixed relative to one another, wherein the holding element (8) surrounds the contacts (12) of the printed circuit (9) in the manner of a frame.

7. Computer system comprising an arrangement according to Claim 6, wherein the computer system is a blade server.

## Revendications

1. Élément de fixation (1) pour une carte d'extension (5) dans un système informatique, l'élément de fixation (1) étant réalisé en forme de clip et comportant au moins deux bras de maintien (4) agrippant au moins en partie une carte d'extension (5) logée dans l'élément de fixation (1), l'élément de fixation (1) étant relié de façon imperdable à la carte d'extension (5) et l'élément de fixation (1) pouvant s'encliqueter au niveau d'un élément de maintien (8) d'un support de module (7), **caractérisé en ce que** l'élément de fixation (1) comporte des premiers moyens de fixation (2) conçus pour fixer une carte d'extension (5) logée dans l'élément de fixation (1) perpendiculairement aux bras de maintien (4) et de telle sorte au niveau de l'élément de fixation (1), que la surface de la carte d'extension (5) est perpendiculaire à la direction longitudinale des bras de maintien (4).

2. Élément de fixation (1) selon la revendication 1, **caractérisé en ce que** les premiers moyens de fixation (2) prennent la forme d'encoches dans lesquelles une carte d'extension (5) peut être fixée.

3. Élément de fixation (1) selon la revendication 1 ou 2, **caractérisé en ce qu'**au niveau des bras de maintien, des deuxièmes moyens de fixation (3) sont disposés (4) pour encliqueter l'élément de fixation (1) au niveau d'un élément de maintien (8) d'un support de module (7).

4. Élément de fixation (1) selon la revendication 3, **caractérisé en ce que** les deuxièmes moyens de fixation (3) prennent la forme de crochets d'encliquetage agrippant par l'arrière un élément de maintien (8) d'un support de module (7) à l'état encliqueté de l'élément de fixation (1).

5. Agencement, comprenant un élément de fixation (1) selon l'une quelconque des revendications 1 à 4 et une carte d'extension (5), la carte d'extension (5) comportant une fiche (6) permettant d'interagir avec les contacts (12) placés sur une platine (9), la fiche (6) étant disposée perpendiculairement à une plaque conductrice de la carte d'extension (5) et la carte d'extension (5) étant ceinte par l'élément de fixation (1) à la façon d'un crochet au niveau du côté opposé à la fiche (6) et étant fixée à l'élément de fixation (1).

6. Agencement selon la revendication 5, comprenant un module doté d'un élément de fixation (1) et d'une carte d'extension (5) ainsi que d'un support de module (7), l'élément de fixation (1) étant encliqueté au niveau d'un élément de maintien (8) du support de module (7) de telle sorte que la fiche (6) de la carte d'extension (5) logée dans l'élément de fixation (1) et les contacts (12) d'une platine (9) fixée sur le support de module (7) sont fixés l'un par rapport à l'autre, l'élément de maintien (8) entourant les contacts (12) de la platine (9) à la façon d'un cadre.

7. Système informatique équipé d'un agencement selon la revendication 6, le système informatique étant un serveur lame.
